Europäisches Patentamt

European Patent Office

Office européen des brevets

(19)

(11) Veröffentlichungsnummer : **0 019 715**
**B1**

(12) **EUROPÄISCHE PATENTSCHRIFT**

(45) Veröffentlichungstag der Patentschrift :
26.01.83

(51) Int. Cl.³ : **H 01 L 39/14**

(21) Anmeldenummer : **80102087.6**

(22) Anmeldetag : **18.04.80**

(54) **Supraleitfähige Schalt- und Speichervorrichtung.**

(30) Priorität : **29.05.79 CH 4980/79**

(43) Veröffentlichungstag der Anmeldung :
**10.12.80 Patentblatt 80/25**

(45) Bekanntmachung des Hinweises auf die Patenterteilung : **26.01.83 Patentblatt 83/04**

(84) Benannte Vertragsstaaten :
**AT DE FR GB**

(56) Entgegenhaltungen :
**US A 3 546 541**

**PROCEEDINGS OF THE IEEE, Band 52, Nr. 10, Oktober 1964, Seiten 1 223-1 233 New York, U.S.A. J. C. MILLER et al. : « The Ryotron — A Variable Inductance Cryogenic Device ».
JOURNAL OF APPLIED PHYSICS, Band 39, Nr. 6, Mai 1968, Seiten 2 579-2 585 New York, U.S.A. S.A. KENEMAN : « Computer Devices ».**

(73) Patentinhaber : **International Business Machines Corporation
Armonk, N.Y. 10504 (US)**

(72) Erfinder : **Jaggi, Rudolf
Hirschweg 3
CH-8135 Langnau/ZH (CH)**

(74) Vertreter : **Schröder, Otto, Dr. Ing.
Säumerstrasse 4
CH-8803 Rüschlikon (CH)**

Jouve, 18, rue St-Denis, 75001 Paris, France

EP 0 019 715 B1

# 0 019 715

## Supraleitfaehige Schalt- und Speichervorrichtung

Die vorliegende Vorrichtung, die den Zustand der Supraleitfähigkeit voraussetzt, verarbeitet elektrische Signale mit hoher Geschwindigkeit. Die Vorrichtung beansprucht wenig Platz und ihr Leistungsverbrauch ist gering. Die Vorrichtung ist insbesondere geeignet zur Anwendung in Datenverarbeitungsanlagen.

Im Stand der Technik sind bereits verschiedene supraleitfähige Schalt- und Verstärkervorrichtungen bekannt. Eine Familie solcher Vorrichtungen geht auf das von D.A. Buck vorgeschlagene « Cryotron » (Proc. IRE Bd. 44 S.482, 1956) zurück. Beim Cryotron wird mittels eines Magnetfeldes ein Supraleiter in den normalen Zustand geschaltet. Dies ist ein nach den Begriffen der modernen Datenverarbeitungstechnik « langsamer Vorgang ». Auch ist der Leistungsverbrauch der Cryotron-Elemente nicht unerheblich.

Eine weitere Familie von Vorrichtungen geht auf den Vorschlag von B. D. Josephson zurück (Phys. Letters, Bd. 1, S. 251, 1962), der die theoretischen Grundlagen zeigt, sowie auf J. Matisoo (Proc. IEEE, Bd. 55, S. 172, 1967), der eine praktisch brauchbare Vorrichtung angab. Die Josephson-Elemente basieren auf der Erscheinung der Elektronentunnelung. Die Tunnelung durch eine dünne Schicht im cryogenischen Zustand ist zweier Zustände fähig, die durch den Tunnelstrom sowie durch ein äusseres Magnetfeld beeinflusst werden können. Ein Nachteil der Josephson-Elemente liegt in der schwierigen Herstellung. Insbesondere die Tunnelschicht, die nicht nur äusserst dünn ist, sondern auch engen Toleranzen genügen muss, ist nicht leicht herzustellen. Zwar beginnen sich Lösungen der Herstellungsprobleme abzuzeichnen, es ist jedoch zu erwarten, dass die Herstellung einigermassen aufwendig sein wird. Auch benötigen die Josephson-Elemente, die heute allgemein in planarer Bauweise hergestellt werden, relativ viel Obenflächenplatz. Demgegenüber steht der Wunsch, möglichst gedrängt zu bauen und dadurch die Verbindungsleitungen innerhalb eines Systems mit vielen Elementen möglichst kurz zu halten.

Das vorgeschlagene Element arbeitet ebenso wie das Josephson-Element ohne Phasenumwandlung, sollte daher eine diesem vergleichbare Arbeitsgeschwindigkeit zeigen. Der Leistungsverbrauch ist ebenfalls dem des Josephson-Elementes vergleichbar. Die Herstellung des Elementes jedoch ist wesentlich einfacher, da beim planaren Aufbau an die verschiedenen Schichten keine Anforderungen gestellt werden müssen, welche beim heutigen Stand der Technik irgendwelche Schwierigkeiten bereiten. Der Platzbedarf des Elementes im planaren Aufbau ist entschieden geringer als derjenige eines vergleichbaren Josephson-Elementes.

Das vorgeschlagene Element beruht auf der physikalischen Erkenntnis, dass die innere Induktivität eines Supraleiters eine Funktion des den Supraleiter umgebenden Magnetfeldes ist. Dies beruht auf nichtlinearen Eigenschaften des supraleitfähigen Materiales. Es wird die Feldabhängigkeit der inneren Induktivität im supraleitenden Zustand, d.h. unterhalb der kritischen Werte für Temperatur, Magnetfeld und Strom ausgenützt. Der Effekt wurde schon in der Literatur erwähnt als « Superinductance Amplification », vgl. V. L. Newhouse, Applied Superconductivity, New York, San Francisco, London, 1975, S.202-204 und dortige Zitate.

Es wurden bereits andere supraleitende Vorrichtungen vorgeschlagen, in welchen die Induktivität eines Leiters durch ein steuerndes Magnetfeld beeinflusst wird, vergleiche USA Patent 3,222,544 (Tsung-Hsin Cheng) sowie R.A. Gange, Proc. IEEE 52,1216 (1964). Die dort beschriebenen und von Gange als « Ryotron » bezeichneten Vorrichtungen unterscheiden sich von der Vorliegenden ganz grundsätzlich. Dort wird die äussere Induktivität eines Supraleiters, dessen Abmessungen gross sind im Vergleich zur Eindringtiefe eines äusseren Magnetfeldes, dadurch beeinflusst, dass ein benachbarter Steuerleiter durch einen elektrischen Strom vom supraleitenden Zustand in den normalleitenden Zustand geschaltet wird. Dieser strominduzierte Phasenübergang in den normalen Zustand bedingt eine hohe Schaltleistung und eine geringe Arbeitsgeschwindigkeit der Vorrichtung.

In der vorliegenden Vorrichtung dagegen sind alle Teile stets im supraleitenden Zustand. Die nichtlinearen Theorien der Supraleitfähigkeit (Ginzburg-Landau, Zh. Eksp. Theor. Fiz. 20, 1064 (1950)) besagen, dass der Ordnungsparameter und dementsprechend die Eindringtiefe $\lambda$ von einem angelegten Magnetfeld H abhängig sind. In ausgedehnten homogenen Supraleitern ist der Einfluss eines Magnetfeldes unterhalb des Phasensprunges jedoch gering. In Supraleitern dagegen, deren Abmessungen klein sind gegenüber der Eindringtiefe $\lambda$, ist eine Zunahme der inneren Induktivität um mehrere Grössenordnungen zu erwarten, bevor das kritische Feld $H_c$ erreicht wird. Experimentelle Daten, die diesen Effekt betreffen, waren bisher schwer zu finden. Immerhin beschreibt L. A. Prozorova die Resultate von bei 9,4 GHz ausgeführten Messungen, vgl. Sowjet Physics JETP Bd. 34, S. 9 (1958). So wurde in Zinn-Filmen mit einer Dicke t ≃ $\lambda$ (0) ein Verhältnis von $\lambda$ (0,9 $H_c$)/$\lambda$(0) ≃ 5 gemessen. Die Angaben zeigen, dass die betreffende Erscheinung schnell abläuft und von hinreichender Grösse ist. Die Erscheinung bildet die Grundlage für die vorliegende Erfindung.

Dementsprechend wird hier eine supraleitfähige Schalt- und Verstärkervorrichtung angegeben, in der ein Supraleiter in Bezug auf ein magnetisches oder magnetisierbares Element so angeordnet ist, dass das magnetische Feld des Elementes den Supraleiter erfasst. Die innere Induktivität des Supraleiters verändert sich dann besonders stark, wenn wenigstens eine laterale Abmessung des Supraleiters vergleichbar mit oder kleiner als die Eindringtiefe des Feldes in das Material des Supraleiters ist. Ist der Supraleiter zweifach zusammenhängend, so wird ein von aussen zugeführter Strom genügender Grösse sich so verteilen, dass er überwiegend in einem Zweig fliesst, während der andere Zweig nahezu stromlos bleibt. Durch äussere Steuerung mit einem Magnetfeld kann der Strom in den anderen Zweig umgeschaltet werden.

Die Erfindung soll nachfolgend anhand von in den Zeichnungen dargestellten Ausführungsbeispielen im einzelnen dargelegt werden.

In den Zeichnungen zeigen :

Figur 1   das Prinzip des Elementes ;

Figur 2   das Prinzip der bistabilen Vorrichtung ;

Figuren 3-7   verschiedene Kennlinien ;

Figur 8   die Einzelzelle eines Datenspeichers ;

Figur 9   ein Teil einer Speichermatrix ;

Figuren 10-12   ein weiteres Ausführungsbeispiel ;

Figur 13   ein Vektordiagramm.

Es ist bekannt, dass die Induktivität eines Supraleiters von der Eindringtiefe abhängt. Die innere Induktivität $L_i$ dünner Drähte und filmförmiger Leiter insbesondere beträgt

$$L_i = \lambda^2 \cdot k, \qquad (1)$$

wobei $\lambda$ die Eindringtiefe und k ein Proportionalitätsfaktor ist. Wird nun ein äusseres Magnetfeld angelegt, so ist die Gesamtinduktivität L die Summe eines feldunabhängigen Wertes $L_0$ und eines Gliedes, das die Feldabhängigkeit beschreibt. In erster Näherung also

$$L = L_0 + \gamma H^2 + ... \qquad (2)$$

Um die Beschreibung zu vereinfachen, werden Glieder höherer Ordnung vernachlässigt. $\gamma$ ist eine Tensor-Komponente für die jeweilige Orientierung des Feldes in Bezug auf den Strom I. Aus (2) bestimmt sich der Fluss $\phi$ zu :

$$\phi = LI = I (L_0 + \lambda H^2) \qquad (3)$$

Daraus ist ersichtlich, dass die Induktivität eines Supraleiters durch ein magnetisches Feld gesteuert werden kann. Es besteht eine gewisse Analogie zum Transistor, wo prinzipiell der Widerstand eines Halbleitersdurch ein elektrisches Feld gesteuert wird.

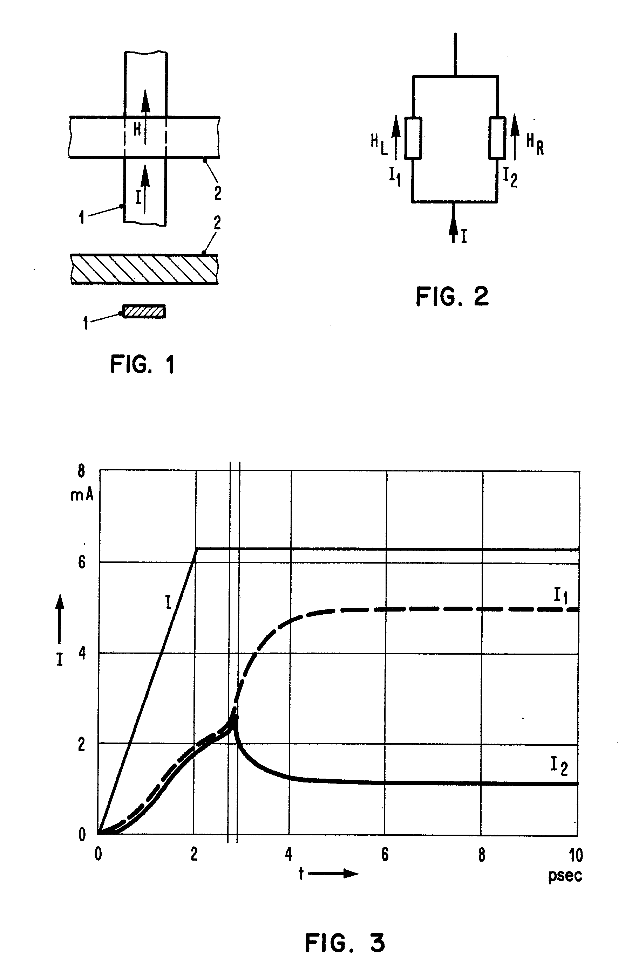

Die Zeichnung der Fig. 1 zeigt in schematischer Darstellung eine Vorrichtung, die das beschriebene Prinzip ausnützt. Die Vorrichtung besteht aus einem Supraleiter 1, durch welchen der Strom I fliesst. Ein äusseres Magnetfeld H, das den Leiter 1 erfasst, soll beispielsweise durch einen im Leiter 2 fliessenden Strom erzeugt sein. Der Leiter 2 soll vom Leiter 1 isoliert sein. Hier sei bemerkt, dass zahlreiche geometrische Anordnungen möglich sind. Die Leiter können aus Drähten, Streifen oder anderen Formen bestehen. Der Querschnitt der Leiter kann konstant sein oder sich entlang der Leiterlänge ändern, Einschnitte aufweisen, etc. Das Magnetfeld H kann longitudinale und transversale Komponenten aufweisen, d.h. es können sich kreuzende oder aber parallele Leiter verwendet werden. Die Leiter können aufeinander geschichtet oder nebeneinander liegend angeordnet sein. Die Leiter können aus Supraleitern des Typs I oder II bestehen, sie können homogen oder geschichtet sein. Auch Supraleiter in Verbindung mit normalen Leitern haben eine stark feldabhängige Eindringtiefe, vgl. G. Deutscher und P. de Gennes : Superconductivity, Bd. 2, S. 1029, (1969), herausgegeben von R.D. Parks. Supraleitende Vorrichtungen dieser Art können als Verstärker, Schalter, logische Elemente, Speicherelemente und zu zahlreichen anderen Funktionen elektronischer Schaltungen verwendet werden. Als Ausführungsbeispiel sei nachfolgend eine bistabile Schaltvorrichtung beschrieben.

Fig. 2 zeigt zwei feldabhängige Leiter, die parallel geschaltet sind. Der Strom I verzweigt sich gemäss dem Kirchhoffschen Gesetz :

$$I = I_1 + I_2 \qquad (4)$$

Es sei angenommen, dass auf den linken Leiter ein externes Magnetfeld $H_1$ sowie das Feld des Stromes $I_2$ im rechten Leiter

$$H'_2 = I_2/b_2 \qquad (5a)$$

einwirkt, wobei $b_2$ eine Länge ist, welche von den geometrischen Verhältnissen abhängt. Das gesamte auf den linken Leiter wirkende Magnetfeld beträgt also

$$H_L = H_1 + H'_2 = H_1 + I_2/b_2 \qquad (5b)$$

Demgemäss gilt für den rechten Leiter mit einem externen Magnetfeld

$$H_2 \text{ und } H'_1 = I_1/b_1 \tag{6a}$$

die Beziehung

$$H_R = H_2 + H'_1 = H_2 + I_1/b_1 \tag{6b}$$

Auf die Parallelschaltung kann nun (3) angewendet werden. Der Einfachheit halber seien gleiche Induktivitäten $L_0$ angenommen, sowie eine feldunabhängige Kopplungsinduktivität $M_0$ und eine geometrisch symmetrische Anordnung, d.h. $b_1 = b_2 = b$. Dann gilt

$$L_0 I_1 + \gamma I_1 (H_1 + I_2/b)^2 + M_0 I_2 = L_0 I_2 + \gamma I_2 (H_2 + I_1/b)^2 + M_0 I_1 \tag{7}$$

Die Elimination von $I_2$ durch Einsetzung von (4) ergibt für $H_1 = H_2 = 0$ eine Gleichung dritten Grades für $I_1$. Diese Gleichung hat drei reelle Lösungen:

$$I_0^* = I_1 = I_2 = I/2 \tag{8}$$

sowie

$$I_{1,2}^* = I/2 \pm \sqrt{I^2/4 - (L_0 - M_0)b^2/\gamma} \tag{9a,b}$$

sofern der Strom

$$I > I_D \tag{10}$$

wobei der diskriminierende Strom $I_D$ sich bestimmt zu

$$I_D = 2b \sqrt{L_0 - M_0/\gamma} \tag{11}$$

Der Ausdruck (10) bedeutet in Worten, dass der Strom I die ursprüngliche Induktivitätsdifferenz $L_0 - M_0$ um mehr als 100 % heraufsetzen muss, damit drei reelle Lösungen möglich sind. Die Berechnung der magnetischen Energie zeigt, dass die Lösung (8) instabil ist, wogegen die Lösungen (9a) und (9b) stabil sind.

Der diskriminierende Strom $I_D$ ist eine kritische Grösse und der der Erfindung zugrunde liegende Schalteffekt tritt auf, wenn diese Grösse überschritten ist, wie (10) und (11) zeigen. Das ist in der Computersimulation der Fig. 3 dargestellt. Diese Darstellung geht davon aus, dass der Anordnung der Fig. 2, d.h. der Parallelschaltung von zwei eng gekoppelten Supraleitern kleiner Abmessungen, zusätzlich noch ein ohmscher Widerstand und eine Kapazität parallel geschaltet sind. Die Kapazität tritt in der Schaltung naturgemäss auf, der Widerstand wird extra zugeschaltet. Wird gemäss Fig. 3 an diese Anordnung ein Strom I derart angelegt, dass er innerhalb von t = 2 ps auf 6,25 mA ansteigt, so steigen die Ströme $I_1$ und $I_2$ zunächst gemeinsam an, bis sie den Wert $I_D = 2 \cdot 2,5 = 5$ mA erreichen. In diesem Moment wird die Schaltung bistabil. Durch geringe natürliche Unsymmetrie wird $I_1 > I_2$ und die Kurve verzweigt sich. Der kritische oder diskriminierende Moment ist durch die senkrechten Doppellinien bei der Zeit t ≈ 3 ps angegeben. Sobald der stabile Zustand der Schaltung erreicht ist, d.h. wenn t > 5 ps, ist $I = I_1 + I_2$. In der Einschaltphase, im Beispiel solange t < 5 ps, ist $I_1 + I_2 < I$ und die Stromdifferenz fliesst in den Kondensator und durch den ohmschen Widerstand. Sobald $I_1$ und $I_2$ konstant sind, ist infolge der Supraleitfähigkeit der Leitungen der Widerstand und der Kondensator wirkungslos, da die an ihnen gelegene Spannung verschwunden ist.

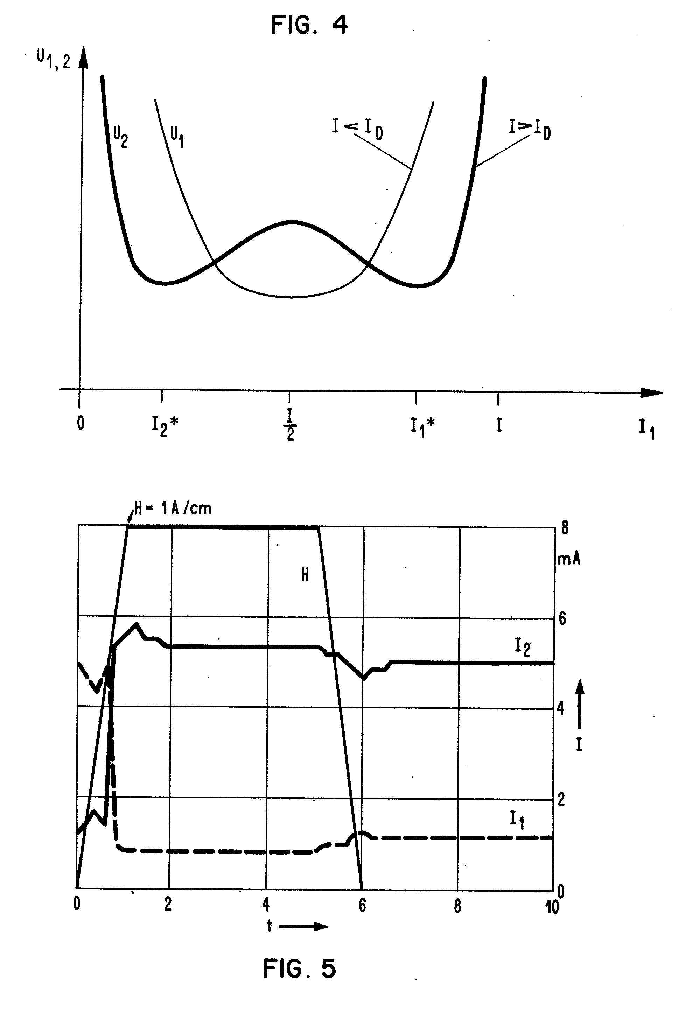

In Fig. 4 ist die Energiefunktion der Schaltung je für den Zustand $I < I_D$ und $I < I_D$ angegeben. Im ersteren Fall fliesst in jedem Zweig der Vorrichtung prinzipiell die Hälfte des Stromes, der die ganze Vorrichtung durchfliesst. Im letzteren Fall ist die Stromverteilung völlig unsymmetrisch, da sich eines der beiden Minima der Kurve einstellen muss. Das ist der Zustand, der in der Fig. 3 für t > 5 ps herrscht.

Nun werden die externen Magnetfelder $H_1$ und $H_2$ angelegt. In einem ersten Beispiel wird $H_2 = -H_1 = -H$ gesetzt. Fig. 5 zeigt den Umschaltvorgang. Die bistabile Arbeitsweise ist offensichtlich. Die Fig. 5 passt an die Fig. 3 und bildet deren Fortsetzung nach rechts. Das Anwachsen des Feldes H veranlasst im Verlauf einiger untergeordneter Störungen eine starke Abnahme von $I_1$ und gleichzeitig eine entsprechende Zunahme von $I_2$. Danach ist der Zustand wieder stabil und $I_1 + I_2 = I$, wobei jetzt aber $I_2 > I_1$ ist. Das Abschalten des Feldes H, das im vorliegendem Beispiel bei t − 5 psec geschieht, erzeugt wiederum nur geringfügige Störungen, beeinträchtigt aber nicht den Schaltzustand.

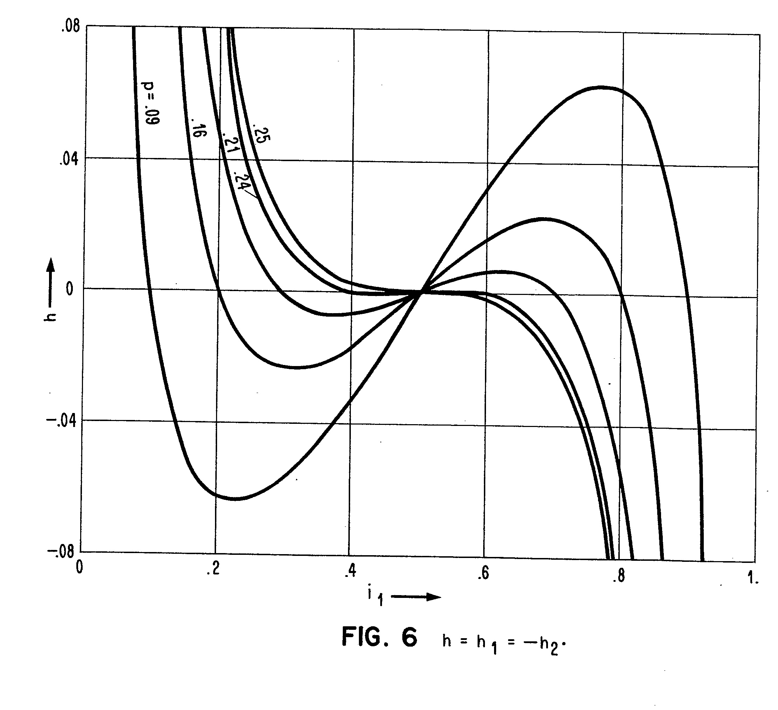

Die Gleichung (7) kann gelöst werden für H als Funktion von $I_1$. Fig. 6 zeigt eine Computersimulation, in welcher das normierte Feld

$$h = b \cdot H/I \tag{12}$$

aufgezeichnet ist als Funktion des normierten Stromes

$$i_1 = I_1/I \tag{13}$$

mit verschiedenen Werten des Parameters

$$p = (L_0 - M_0)\ b^2/\gamma I^2 = (I_D/2I)^2 \tag{14}$$

Die $H - I_1$ Kurven sind in diesem Fall symmetrisch.

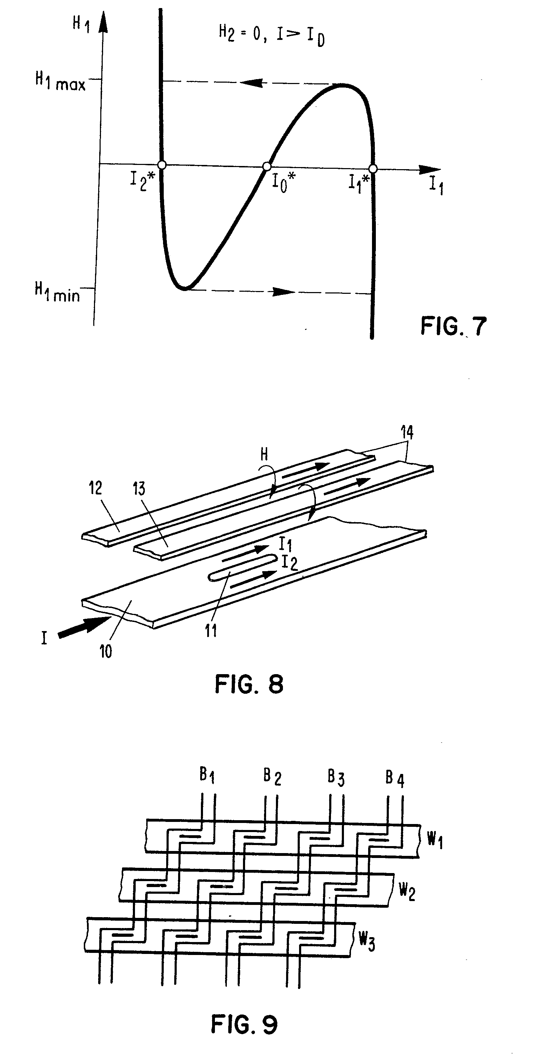

In Fig. 7 ist eine unsymmetrische Umschaltlinie für $H_1$ als Funktion von $I_1$ gezeigt, wobei $H_2 = 0$. Wird zunächst bei einem Strom $I_1 = I_1^*$ das Magnetfeld $H_1$ von Null an über den Wert $H_{1max}$ gesteigert, dann schaltet die Vorrichtung entlang der gebrochenen Linie auf den linken Ast der $H_1 = I_1$ Kurve. Wird darauf das Feld $H_1$ wieder auf 0 reduziert, so bleibt der Strom auf dem stabilen Wert $I_2^*$. Wird das Feld $H_1$ weiter vermindert unterhalb den Wert $H_{1min}$, so schaltet die Vorrichtung auf den rechten Zweig der $H_1 - I_1$ Kurve. Für $H_1 = 0$ nimmt der Strom wieder seinen Anfangswert $I_1^*$ an. Da der gesammte Schaltvorgang im supraleitenden Zustand abläuft und somit kein Phasenübergang stattfindet, handelt es sich um einen schnellen Vorgang. Im Ruhezustand wird zudem keine Leistung verbraucht.

Andere Beispiele mit einer Vorspannung durch ein externes Feld oder mit Dauerströmen im Kreis können aufgezeigt werden.

Als praktisches Ausführungsbeispiel soll eine einfache Zelle in Planartechnologie aufgezeigt werden. Solche Zellen können als Speicherelemente in Matrizen benützt werden.

Fig. 8 zeigt die streifenförmige Leitung 10, die eine schlitzartige Oeffnung 11 aufweist. Die supraleitfähige Leitung 10 ist z.B. auf bekannte Weise auf ein nicht dargestelltes Substrat aufgebracht. Die Leitung 10 ist von einer ebenfalls nicht dargestellten isolierenden Schicht bedeckt, die ihrerseits die Leitungsstreifen 12 und 13 trägt. Anders als in der Zeichnung dargestellt, liegen diese Schreib-Leseleitungen ganz dicht über der Leitung 10 und bedecken diese nahezu völlig. Das von den Schreib-Leseleitungen 12, 13 erzeugte Feld H steht hier orthogonal zu dem Strom I, respektive $I_1$ und $I_2$.

Ein durch die Leitung 10 fliessender Strom genügender Grösse $I > I_D$ verzweigt sich vor dem Schlitz 11 und fliesst im wesentlichen auf einer Seite desselben. Soll zu Anfang ein Null-Bit eingeschrieben sein, so wird zunächst ein Strom in Pfeilrichtung durch die Leitung 13 geschickt. Das entstehende Magnetfeld H wirkt stärker auf den Pfad von $I_2$ und erhöht dessen innere Induktivität mehr als die des Pfades von $I_1$. Es wird sich daher der Zustand $I_1 > I_2$ einstellen, der ein gespeichertes Null-Bit bedeuten soll. Auf entsprechende Weise wird ein Eins-Bit gespeichert, indem ein Strom in Pfeilrichtung durch die Leitung 12 geschickt wird. Dieser Strom bewirkt, dass $I_1 < I_2$ wird.

Zum Auslesen der gespeicherten Information werden die Enden 14 der Leitungen 12 und 13 miteinander verbunden. Wird nun der Strom I in der Leitung 10 abgeschaltet, so wird in der durch die Leitungen 12 und 13 gebildeten Schleife ein Signal induziert, das durch einen Verstärker bekannter Art ausgewertet wird. Die Polarität dieses Signales zeigt dann an, ob ein Null- oder ein Eins-Bit gespeichert war. Diese Art auszulesen ist informationszerstörend, das heisst, die Information muss neu eingespeichert werden, sofern sie erhalten bleiben soll. Verfahren dazu sind hinreichend bekannt und hier deshalb nicht beschrieben. Die Schaltung kann so ausgelegt werden, dass die nebeneinanderliegenden Enden der beiden Leitungen 14 geerdet, z.B. mit der Grundplatte verbunden sind. An den Anfängen 12, 13 ist eine logische Schaltvorrichtung angeschlossen, die einerseits einen symmetrisch gegen Erde auftretenden Lesepuls feststellen und dessen Polarität bestimmen kann, und die andererseits je eine der Leitungen mit einem Schreibpuls versorgen kann, der über die Erde respektive die Grundplatte abfliesst. Derartige Schaltungen sind dem Fachmann geläufig, sie werden daher nicht in weiteren Einzelheiten hier beschrieben.

Fig. 9 zeigt, wie eine Vielzahl von Zellen nach Fig. 8 in einer Speichermatrix angeordnet ist. Die waagrechten Leitungen, die der Leitung 10 entsprechen, bilden die Wortleitungen und die diagonal verlaufenden, den Leitungen 12 und 13 entsprechenden Paare, bilden die Bitleitungen der Speichermatrix.

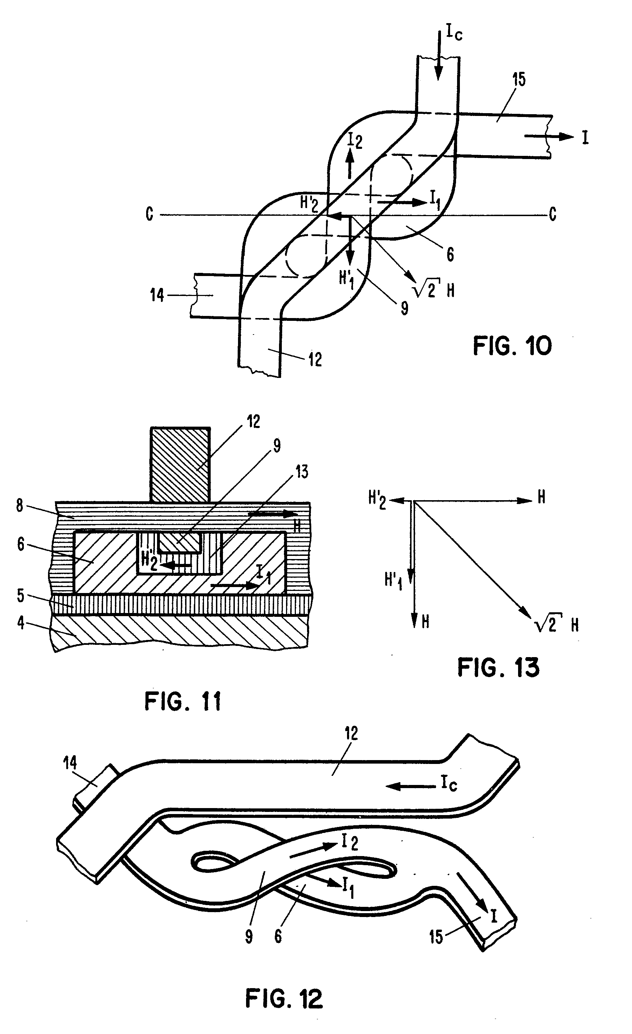

Das zweite Beispiel, das in Fig. 10 dargestellt ist, zeigt eine andere Ausführung der Speicherzelle. Fig. 11 zeigt den Querschnitt durch die Vorrichtung gemäss Fig. 10 entlang der Schnittlinie C-C. Die Vorrichtung, die die Form der Zahl 8 aufweist, entspricht einem Grundelement gemäss Fig. 1, in dem das Feld H dem Strom I parallel liegt. Zum besseren Verständnis zeigt Fig. 12 eine auseinandergezogene perspektivische Ansicht der Speicherzelle nach Fig. 10. Die diagonale Steuerleitung 12 erzeugt das externe Magnetfeld in der gewünschten Richtung. Im Querschnitt der Fig. 11 sind die einzelnen Schichten des planaren Aufbaus gleich numeriert wie in der Fig. 10.

Auf dem Substrat 4, Fig. 11, ist eine isolierende Schicht 5 angeordnet, die den unteren Leitungszweig 6 des zweifach zusammenhängenden, eine der Zahl 8 ähnliche Schleife bildenden Supraleiters trägt. In einer Vertiefung dieses Zweiges ist, getrennt durch die Isolation 13, der andere Zweig 9 eingelassen. Dieser ist durch die Isolation 8 abgedeckt, die ihrerseits die Steuerleitung oder Schreib-Leseleitung 12 trägt. Die Zweige 6 und 9 des Supraleiters vereinigen sich in den Enden 14 und 15, an welche der Strom I angelegt wird.

Fig. 13 zeigt die vektorielle Zusammensetzung der Magnetfelder in der Zelle nach Fig. 10-12. Der Zustand der Zelle sei zunächst $I_1 > I_2$. $I_1$ erzeugt daher im Schnittpunkt der beiden Leitungszweige das zu diesem Strom senkrecht verlaufende Magnetfeld $H'_1$. Dieses zeigt in Fig. 13 nach unten, da der betreffende Leitungszweig zu unterst liegt und daher die über ihm verlaufende Feldkomponente auf den anderen Leitungszweig wirkt. Der kleinere Strom $I_2$ erzeugt dagegen in dem unter ihm liegenden Leitungszweig das Feld $H'_2$. Der Steuerstrom $I_c$, der nun die diagonale Leitung durchfliesst, erzeugt ein Feld $\sqrt{2}\,H$ mit den wirksamen Komponenten H. Diese addieren sich zu $H'_1 + H$ sowie $H'_2 + H$, wobei hier $H'_1 + H > H'_2 + H$. Es erfolgt die Umschaltung. Fliesst jedoch $I_c$ in der entgegengesetzten Richtung, so erfolgt, wie aus Fig. 13 herzuleiten ist, die Umschaltung auf den Zustand $I_1 < I_2$ nicht.

Beim Auslesen der Zelle durch Abschalten des Stromes I wird, wie leicht ersichtlich ist, in der diagonalen Leitung ein Lesepuls erzeugt. Dabei wirkt die diagonale Komponente des vom Strom I erzeugten Feldes. Es ist aus Fig. 13 herzuleiten, dass die Polarität dieses Lesestromes davon abhängt, ob $H'_1 > H'_2$ oder aber $H'_1 < H'_2$.

Dieses Ausführungsbeispiel ist in der Herstellung etwas komplizierter als das der Fig. 8. Es hat diesem gegenüber aber den Vorteil, nur eine einzige Leitung für Lesen und Schreiben zu benötigen. Der Platzbedarf ist daher etwas geringer.

Zur Herstellung der vorliegenden Vorrichtungen kommen praktisch alle supraleitfähigen Materialien in Frage, so z.B. Blei, Indium, Zinn, sowie deren Legierungen. Da die Eindringtiefe $\lambda$ und die Grösse $\gamma$, welche die Feldabhängigkeit von $\lambda$ beschreibt, vom Material abhängige Grössen sind, wird man bei der Wahl des Materials auf diese gebührend Rücksicht nehmen. Zinn, Blei und Blei-Indium-Legierungen haben sich als vorteilhafte Materialien erwiesen.

Wesentlich an der Erfindung ist, dass in einem zweifach zusammenhängenden Supraleiter ein Strom sich asymmetrisch auf die magnetisch gekoppelten Zweige verteilt, wenn wenigstens eine laterale Abmessung dieser Zweige kleiner oder vergleichbar mit der Eindringtiefe ist, und wenn der Strom einen diskrimminierenden Wert übersteigt. Der zweifach zusammenhängende Leiter kann durch Verzweigung und Wiedervereinigung oder durch Anbringen einer Oeffnung, z.B. eines Schlitzes oder Loches, gebildet werden. Die Oeffnung kann körperlich ausgebildet oder magnetisch durch lokale Beseitigung der Supraleitfähigkeit hervorgerufen sein. So kann z.B. an der betreffenden Stelle ein Vortex, wie in Typ II - Supraleitern bekannt, gebildet werden und die Funktion der Oeffnung übernehmen.

Der Fachmann wird ohne Weiteres zahlreiche andere Ausführungsformen erkennen, die auf der vorliegenden Erfindung beruhen.

## Ansprüche

1. Supraleitende bistabile Schalt- und Speichervorrichtung, dadurch gekennzeichnet, daß deren supraleitende Leitungen zwecks Beeinflussung der Induktivität durch ein Magnetfeld wenigstens in einer Dimension vergleichbar mit oder kleiner als die Eindringtiefe des Feldes in diese Leitungen sind, dass ein Leiter sich über eine bestimmte Länge in zwei Zweige teilt, die magnetisch miteinander so gekoppelt sind, dass ein Strom bestimmter Grösse im Leiter im wesentlichen nur in einem Zweig fliessen kann, und dass wenigstens eine Schreib-Leseleitung magnetisch mit wenigstens einem der Zweige zusammenwirkt.

2. Vorrichtung nach Anspruch 1 mit auf einem Substrat aufgebrachten Leitungen, dadurch gekennzeichnet, dass der verzweigte Leiter in der Nähe von zwei magnetisch mit ihm zusammenwirkenden, jedoch dielektrisch von ihm isolierten Schreib-Leseleitungen angeordnet ist, und mit diesen parallel verläuft (Fig. 8).

3. Vorrichtung nach Anspruch 1 mit auf einem Substrat aufgebrachten Leitungen, dadurch gekennzeichnet, dass der verzweigte Leiter in der Nähe einer mit ihm magnetisch zusammenwirkenden Schreib-Leseleitung angeordnet ist und mit dieser parallel verläuft.

4. Vorrichtung nach Anpruch 1, dadurch gekennzeichnet, dass die Schreib-Leseleitung orthogonal zum Leiter verläuft.

5. Vorrichtung nach Anspruch 1, dadurch gekennzeichnet, dass der Querschnitt eines der Zweige des Supraleiters grösser ist als der Querschnitt des anderen Zweiges.

6. Vorrichtung nach Anspruch 1, mit auf einem Substrat aufgebrachten Leitungen, dadurch gekennzeichnet, dass die Zweige im Bereich magnetischer Kopplung wenigstens angenähert parallel verlaufen (Fig. 2, 8, 9).

7. Vorrichtung nach Anspruch 1, mit auf einem Substrat aufgebrachten Leitungen, dadurch gekennzeichnet, dass der verzweigte Leiter derart angeordnet ist, dass die Zweige sich im Bereich magnetischer Kopplung in wenigstens angenähert rechtem Winkel kreuzen und dass diese Kreuzung zudem mit wenigstens einer Schreib-Leseleitung magnetisch gekoppelt ist (Fig. 10-13).

## Claims

1. Superconductive bistable switching- and storage device, characterized in that it comprises a superconductor having at least one dimension which is, in order to permit control of the inductivity by application of a magnetic field, comparable to or smaller than the penetration depth of said field into the superconductor, that the superconductor divides into two branches over a certain length, said branches having mutual magnetic coupling such that a current of a certain magnitude in said superconductor will flow essentially in only one branch thereof, and that at least one read/write line is provided which magnetically co-acts with at least one of said branches.

2. Device according to claim 1 with the superconductor arranged on a substrate, characterized in that the divided superconductor is located adjacent to two read/write lines magnetically co-acting with the superconductor but which are electrically insulated therefrom and which extend in a direction parallel to that of the superconductor. (Fig. 8).

3. Device according to claim 1 with the superconductor arranged on a substrate, characterized in that the divided superconductor is located adjacent to a single read/write line magnetically coacting with the superconductor and extending in a direction parallel to that of the superconductor.

4. Device according to claim 1, characterized in that the read/write line extends in a direction orthogonal to that of the superconductor.

5. Device according to claim 1, characterized in that the cross-section of one branch of the superconductor is larger than the cross-section of the other branch.

6. Device according to claim 1 with the superconductor arranged on a substrate, characterized in that said branches extend in directions approximately parallel to each other in the region of magnetic coupling. (Fig. 2, 8, 9).

7. Device according to claim 1 with the superconductor arranged on a substrate, characterized in that the divided superconductor is arranged such that its branches extend in directions essentially orthogonal to each other and cross over in the region of magnetic coupling, and in that the cross over is magnetically coupled with at least one read/write line. (Fig. 10-13).

**Revendications**

1. Dispositif d'emmagasinage et de commutation bistable supraconducteur caractérisé en ce qu'il comprend un supraconducteur présentant au moins une dimension qui est, afin de permettre la commande de l'inductivité par l'application d'un champ magnétique, égale ou inférieure à la profondeur de la pénétration dudit champ dans le supraconducteur, en ce que le supraconducteur se divise en deux branches sur une certaine longueur, lesdites branches présentant un couplage magnétique mutuel tel qu'un courant d'une certaine grandeur dans ledit supraconducteur ne s'écoulera essentiellement que dans une branche seulement de celui-ci, et en ce qu'au moins une ligne de lecture/écriture est prévue pour coopérer magnétiquement avec au moins l'une desdites branches.

2. Dispositif selon la revendication 1, dans lequel le supraconducteur est agencé sur un substrat, caractérisé en ce que le supraconducteur divisé est disposé adjacent à deux lignes de lecture/écriture coopérant magnétiquement avec le superconducteur mais qui sont électriquement isolées de celui-ci et disposées dans une direction parallèle à celle du supraconducteur (Fig. 8).

3. Dispositif selon la revendication 1, dans lequel le supraconducteur est agencé sur un substrat, caractérisé en ce que le supraconducteur divisé est disposé adjacent à une ligne de lecture/écriture unique coopérant magnétiquement avec le supraconducteur et disposée dans une direction parallèle à celle du supraconducteur.

4. Dispositif selon la revendication 1, caractérisé en ce que la ligne de lecture/écriture est disposée dans une direction orthogonale à celle du supraconducteur.

5. Dispositif selon la revendication 1, caractérisé en ce que la section d'une branche du supraconducteur est plus grande que la section de l'autre branche.

6. Dispositif selon la revendication 1, dans lequel le supraconducteur est agencé sur un substrat, caractérisé en ce que lesdites branches sont orientées dans des directions approximativement parallèles entre elles dans la zone de couplage magnétique (Fig. 2, 8, 9).

7. Dispositif selon la revendication 1, dans lequel le supraconducteur est agencé sur un substrat, caractérisé en ce que le supraconducteur divisé est disposé de telle sorte que ses branches sont orientées dans des directions essentiellement orthogonales entre elles et se recouvrent dans la zone de couplage magnétique, et en ce que le recouvrement est couplé magnétiquement avec au moins une ligne de lecture/écriture (Fig. 10, 13).

FIG. 1

FIG. 2

FIG. 3

1

# FIG. 4

# FIG. 5

FIG. 6  $h = h_1 = -h_2.$

0 019 715

$H_2 = 0,\ I > I_D$

FIG. 7

FIG. 8

FIG. 9

4

FIG. 10

FIG. 11

FIG. 13

FIG. 12

5